# EUROPEAN PATENT SPECIFICATION

(11) **EP 3 703 115 B1**
(45) Date of publication and mention of the grant of the patent: **12.06.2024**
(21) Application number: 17930029.8
(22) Date of filing: 27.10.2017
(51) Int. Cl.: H01L 23/36, H01L 23/373, H01L 23/367, H01L 23/42, H01L 23/492

(54) **SEMICONDUCTOR DEVICE**
HALBLEITERBAUELEMENT
DISPOSITIF SEMICONDUCTEUR

(43) Date of publication of application: 02.09.2020
(73) Proprietor: Nissan Motor Co., Ltd., Yokohama-shi, Kanagawa 221-0023 (JP)
(72) Inventor: TOMITA, Yosuke, Atsugi-shi, Kanagawa 243-0123 (JP); HAYASHI, Tetsuya, Atsugi-shi, Kanagawa 243-0123 (JP); YAMAGAMI, Shigeharu, Atsugi-shi, Kanagawa 243-0123 (JP); NUMAKURA, Keiichiro, Atsugi-shi, Kanagawa 243-0123 (JP); HAYAMI, Yasuaki, Atsugi-shi, Kanagawa 243-0123 (JP); IWASAKI, Yuichi, Atsugi-shi, Kanagawa 243-0123 (JP)
(74) Representative: Hoefer & Partner Patentanwälte mbB
(86) International application number: PCT/JP2017/038868
(87) International publication number: WO 2019/082371

(56) References cited:
- EP-A2- 1 187 199
- DE-A1- 10 234 995
- JP-A- 2000 150 743
- JP-A- 2006 202 798
- JP-A- 2006 210 575
- JP-A- 2008 159 995
- JP-A- 2016 026 391
- JP-A- 2016 100 401
- JP-B2- 5 784 261
- US-A1- 2001 024 724
- US-A1- 2011 083 836

## Description

### TECHNICAL FIELD

The present invention relates to a semiconductor device, and in particular to a technology for improving heat dissipation efficiency.

### BACKGROUND ART

There has been known a semiconductor device disclosed in Patent Literature 1, for example, as a semiconductor device configured to efficiently dissipate heat to be generated in a semiconductor element in order to prevent overheating. Patent Literature 1 discloses that an insert component composed of highly oriented pyrolytic graphite which has an anisotropic thermal conductivity characteristic is installed on a substrate in a cross shape in planar view, and a heat-generating component is bonded to a front side surface thereof, heat generated from the heat-generating component is diffused to the entire substrate, thereby improving heat dissipation efficiency.
From JP 2006 202798 A, a configuration of a device is known, in which a substrate of a base fixed with heat dissipation fins, a plurality of heat diffusion plates for transporting heat through phase transformation of working fluid are arranged oppositely to an installation position of a plurality of heat generating bodies.
From JP 2006 210575 A, a package for a semiconductor device is known which comprises a wiring board formed of resin, a semiconductor device flip-chip connected to the resin wiring board via a solder bump, a high heat conductive cover mounted on the surface of the resin wiring board to cover the semiconductor device and is in contact with the upper surface of the semiconductor device at a part thereof, and a connecting terminal (solder ball) provided at the backside of the resin wiring board and is electrically connected with the semiconductor device.
From EP 2 454 551, an anisotropic thermal conductive element is known that can conduct heat from a heat source, a structure with a stack of graphite sheets having a contact surface across the thickness direction of the graphite sheets, and the stack of graphite sheets has the surroundings thereof coated to form a support parts. The coating process covers the structure of stacked graphite with a support part. A cutting process can be performed by cutting along the surface in the stacking direction after the coating process. After the cutting process, a surface treatment process can make a surface treatment to a section.

### CITATION LIST

### PATENT LITERATURE

Patent Literature 1: Japanese Patent No. 4939214

### SUMMARY OF INVENTION

### TECHNICAL PROBLEM

However, in the conventional example disclosed in the above-mentioned Patent Literature 1, since the insert component is provided in the cross shape although the heat is diffused using the insert component which has the anisotropic thermal conductivity characteristic, there has been a problem that the heat dissipation efficiency could not be further improved.

The present invention has been made in light of the above-mentioned problem, and the object of the present invention is to provide a semiconductor device capable of improving heat dissipation efficiency.

### SOLUTION TO PROBLEM

This object is solved by the features of the independent claim. The dependent claims contain advantageous embodiments of the present invention.

### ADVANTAGEOUS EFFECTS OF INVENTION

According to the semiconductor device according to the present invention, the heat dissipation efficiency can be improved.

### BRIEF DESCRIPTION OF DRAWINGS

[Fig. 1] Fig. 1 is a top view diagram of a semiconductor device according to one embodiment of the present invention.
[Fig 2] Fig. 2 is cross-sectional diagram taken in the line A-A' of the semiconductor device shown in Fig. 1.
[Fig 3] Fig. 3 is a cross-sectional diagram taken in the line B-B' of the semiconductor device shown in Fig. 1.
[Fig. 4] Fig. 4 is a graphic chart showing a relationship between a ratio of a width of a thermally conductive member with respect to a width (a length in a Y-axial direction) of a semiconductor element, and a thermal resistance ratio in a case where a thickness of the thermally conductive member is 2 mm.
[Fig. 5] Fig. 5 is a graphic chart showing a relationship between the ratio of the width of the thermally conductive member with respect to the width (the length in the Y-axial direction) of the semiconductor element, and the thermal resistance ratio in a case where the thickness of the thermally conductive member is 5 mm.
[Fig. 6A] Fig. 6A is an explanatory diagram showing a Y-Z-axial plane and diffusion of heat when the ratio L6/L5 is less than 70%.
[Fig. 6B] Fig. 6B is an explanatory diagram showing the Y-Z-axial plane and diffusion of heat when the ratio L6/L5 is within a range of 70% to 95%.
[Fig. 6C] Fig. 6C is an explanatory diagram showing the Y-Z-axial plane and diffusion of heat when the ratio L6/L5 is more than 95%.
[Fig. 7A] Fig. 7A is an explanatory diagram showing the Y-Z-axial plane and diffusion of heat when the semiconductor element overlaps with the thermally conductive member.
[Fig. 7B] Fig. 7B is an explanatory diagram showing the Y-Z-axial plane and diffusion of heat when a part of thermally conductive member is exposed therefrom.
[Fig. 8A] Fig. 8A is an explanatory diagram showing the Y-Z-axial plane and diffusion of heat when the thickness of the metal member is larger than the thickness of the thermally conductive member.
[Fig. 8B] Fig. 8B is an explanatory diagram showing the Y-Z-axial plane and diffusion of heat when the thickness of the metal member is identical to the thickness of the thermally conductive member.
[Fig. 9] Fig. 9 shows a graphic chart in which the horizontal axis a ratio of a length L3 to a thickness L12 of the metal member and the vertical axis is the thermal resistance ratio.

### DESCRIPTION OF EMBODIMENTS

Hereinafter, there will be explained embodiments with reference to the drawings.

### [Description of a configuration of the present embodiment]

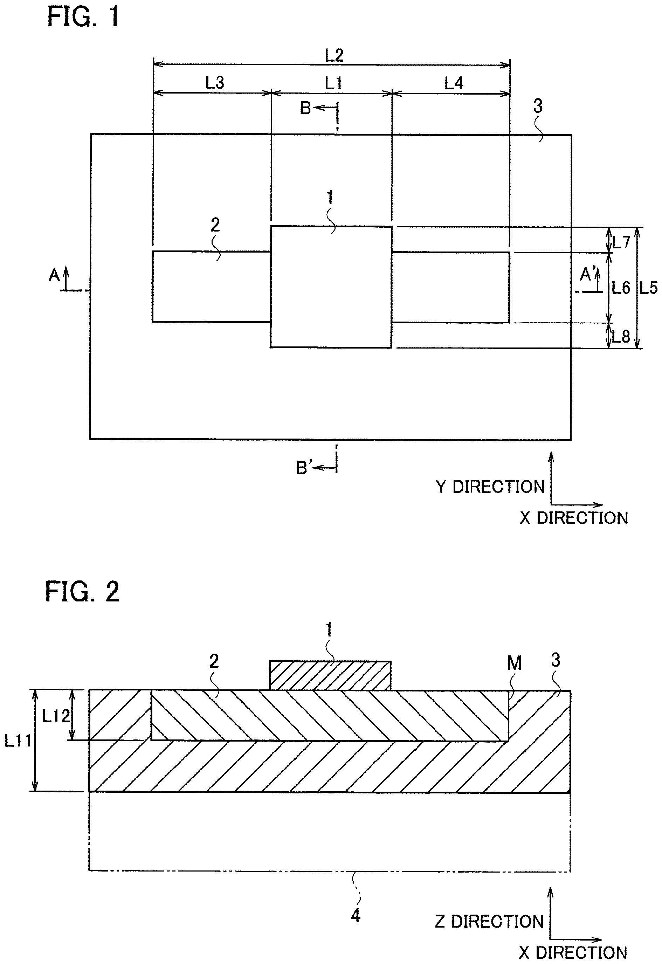

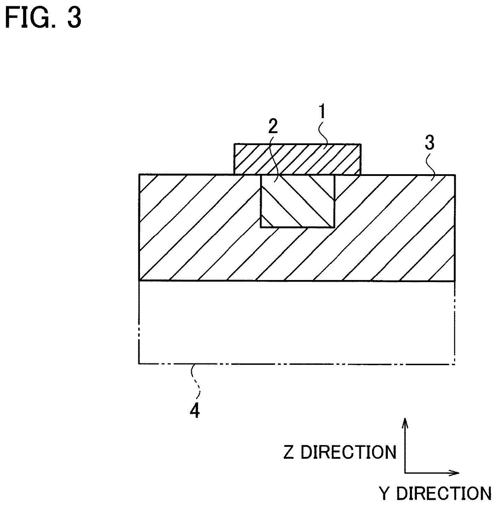

Fig. 1 is a top view diagram of a semiconductor device according to one embodiment of the present invention, Fig. 2 is a cross-sectional diagram taken in the line A-A' of Fig. 1, and Fig. 3 is cross-sectional diagram taken in the line B-B' of Fig. 1. In the following description for convenience, a right-left direction of the top view diagram shown in Fig. 1 is an X-axial direction (first axial direction on a front side surface of a metal member 3), an up-and-down direction (direction orthogonal to the X-axis) shown in Fig. 1 is a Y-axial direction (second axial direction on the front side surface of metal member 3), and an up-and-down direction of the side view diagram shown in Fig. 2 is a Z-axial direction. In other words, the right-left direction in Fig. 2 corresponds to the X-axial direction, the up-and-down direction in Fig. 3 corresponds to the Z-axial direction, and the right-left direction in Fig. 3 corresponds to the Y-axial direction.

As shown in Figs. 1 to 3, the semiconductor device according to the present embodiment includes a metal member 3 having a rectangular shape that is long in the X-axial direction in planar view (surface observed from the Z-axial direction), and a long groove M is formed in the X-axial direction on an upper surface of the metal member 3. A thermally conductive member 2, such as graphite, is provided in the inside of the aforesaid trench M. The front side surface of the metal member 3 is flush with the front side surface of thermally conductive member 2.

Furthermore, a semiconductor element 1 having a rectangular shape in planar view, and having a length in the X-axial direction is L1 and a length in the Y-axial direction is L5 is bonded on the upper surface of the thermally conductive member 2, and their centers coincide with each other. In addition, the semiconductor element 1 may have a square shape. The thermally conductive member 2 has a rectangular shape that is long in the X-axial direction, and therefore the thermally conductive member 2 protrudes from the semiconductor element 1 in the X-axial direction. In other words, the length L2 in the X-axial direction of the thermally conductive member 2 is longer than the length L1 in the X-axial direction of the semiconductor element 1, and the thermally conductive member 2 protrudes by the lengths L3 and L4 in the X-axial direction. When the semiconductor element 1 is arranged at the center of the thermally conductive member 2, L3=L4 is satisfied.

On the other hand, the semiconductor element 1 protrudes from the thermally conductive member 2 in the Y-axial direction. In other words, the length L5 (L5=L1 is satisfied when the semiconductor element 1 has a square shape) in the Y-axial direction of the semiconductor element 1 is longer than the length L6 in the Y-axial direction of the thermally conductive member 2, and the semiconductor element 1 protrudes by the lengths L7 and L8 in the Y-axial direction. When the semiconductor element 1 is arranged at the center of the thermally conductive member 2, L7=L8 is satisfied.

For example, bonding using solder can be used, as a method of bonding between the metal member 3 and the thermally conductive member 2 and a method of bonding between the thermally conductive member 2 and the semiconductor element 1. Alternatively, it is also possible to bond them with a resin material having electrical conductivity and thermal conductivity, or to bond them with pressure welding or the like, instead of the bonding with solder.

The thermally conductive member 2 is a plate-shaped member formed by laminating materials having high thermal conductivity in a planar direction in a layered manner, and the thermal conductivity in the Y-axial direction is relatively higher than the thermal conductivity in the X-axial direction. More specifically, the thermal conductivity is relatively high in the X-axial direction and the Z-axial direction, and the thermal conductivity is relatively low in Y-axial direction shown in Figs. 1 to 3. In the present embodiment, the thermally conductive member 2 is configured by laminating thin thin-plate-shaped and rectangular graphite, as an example. The front side surface of the thermally conductive member 2 may be covered with a metal (not shown) for bonding.

Copper can be used for the metal member 3, as an example. A copper alloy, aluminum, an aluminum alloy, or the like may be used in addition to copper.

A cooling apparatus 4 for thermally dissipating heat of the metal member 3 is bonded to a back side surface (back side surface opposite to the front side surface) of the metal member 3 with an insulating materials (not shown) interposed therebetween. Any one of a water-cooling type, an oil injection type, or air-cooling type can be used for the cooling apparatus 4.

Moreover, in the present embodiment, the sizes of the semiconductor element 1, the thermally conductive member 2, and the metal member 3 are set, as shown in the following (1) to (4).

(1) The lengths L5 and L6 are set so that the ratio "L6/L5" of the length L6 in the Y-axial direction (second axial direction) of the thermally conductive member 2 with respect to the length L5 in the Y-axial direction (second axial direction) of the semiconductor element 1 is equal to or more than 40% (preferably equal to or more than 70% and equal to or less than 95%).
   Alternatively, the size of at least one of the semiconductor element 1 and the thermally conductive member 2 is set so that the ratio of an area where the semiconductor element 1 and the thermally conductive member 2 overlap one another to a area of the semiconductor element 1 in planar view (normal direction view of the front side surface of the semiconductor element 1) is equal to or more than 40% (preferably equal to or more than 70% and equal to or less than 95%).
(2) In the Y-axial direction, the semiconductor element 1 is arranged so as to completely cover the thermally conductive member 2. That is, as shown in Fig. 1, when bonding the semiconductor element 1 to the upper surface of the thermally conductive member 2, the semiconductor element 1 is arranged so as to overlap the thermally conductive member 2 in the Y-axial direction. Consequently, the lengths L7 and L8 shown in Fig. 1 become positive numerical values. In other words, one end in the Y-axial direction (second axial direction) of the semiconductor element 1 is extended from one end in the Y-axial direction (second axial direction) of the thermally conductive member 2, and the other end in the Y-axial direction (second axial direction) of the semiconductor element 1 is extended from the other end in the Y-axial direction (second axial direction) of the thermally conductive member 2.
(3) As shown in Fig. 2, the thickness L11 of the metal member 3 is made longer than the thickness L12 of the thermally conductive member 2. In other words, the length in the normal direction to the front side surface of the metal member 3 is made longer than the length in the normal direction to the front side surface of the thermally conductive member 2.
(4) The length (L3 and L4 shown in Fig. 1) of the region of the both ends of the thermally conductive member 2 which is not in contact with the semiconductor element 1 is made equal to or more than the thickness (L11 shown in Fig. 2) of the metal member 3 in the X-axial direction. In other words, the length in the X-axial direction (first axial direction) of the thermally conductive member 2 is longer than the length in the X-axial direction (first axial direction) of the semiconductor element 1; and the length from one end in the X-axial direction (first axial direction) of the semiconductor element 1 to one end in the X-axial direction (first axial direction) of the thermally conductive member 2 and the length from the other end in the X-axial direction (first axial direction) of the semiconductor element 1 to the other end in the X-axial direction (first axial direction) of the thermally conductive member 2 are equal to or more than the length in the normal direction to the front side surface of the metal member 3.

### [Description of effects of the present embodiment]

Next, effects of the semiconductor device according to the present embodiment configured as described above will now be described. As shown in Fig. 1, the thermally conductive member 2 having the rectangular shape in planar view is provided on the front side surface of the metal member 3, and the semiconductor element 1 is bonded so as to be in contact with this thermally conductive member 2. For this reason, heat generated in the semiconductor element 1 is initially diffused in the X-axial direction through the thermally conductive member 2, and is then is diffused to the entire metal member 3. In other words, the heat generated in the semiconductor element 1 is early diffused to a wide range (region of the thermally conductive member 2), and the heat is then transferred to the metal member 3 from the thermally conductive member 2. In this case, since a part of the semiconductor element 1 is in contact with the metal member 3, the heat remaining in the semiconductor element 1 (heat which is not diffused through the thermally conductive member 2) can be thermally dissipated through the metal member 3. Furthermore, the heat diffused to the metal member 3 is thermally dissipated to the outside through the cooling apparatus 4.

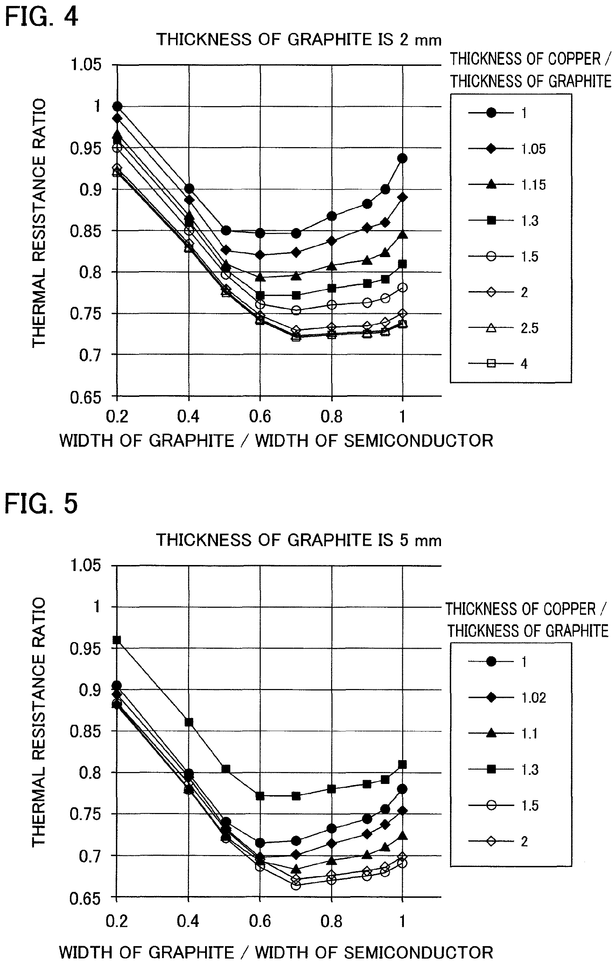

Next, the reason for making the above-mentioned ratio "L6/L5" is set to equal to or more than 40% (preferably 70 to 95%) will now be described. Each of Figs. 4 and 5 is a graphic chart in which the horizontal axis is a ratio (i.e., "L6/L5") of a width of the thermally conductive member 2 with respect to a width (a length in the Y-axial direction) of the semiconductor element1, and the vertical axis is a thermal resistance ratio (thermal resistance ratio obtained by normalizing a thermal resistance in a case where the width of the thermally conductive member 2 is 1 mm, the thickness thereof is 2 mm, and the thickness of the metal member 3 is 2 mm). Fig. 4 shows the case where the thickness of the thermally conductive member 2 is 2 mm, and Fig. 5 shows the case where the thickness of the thermally conductive member 2 is 5 mm.

As shown in Figs. 4 and 5, it is understood that sensitivity of thermal resistance ratio with respect to the ratio "L6/L5" is low and the thermal resistance ratio itself is also low, when the above-mentioned ratio "L6/L5 is equal to or more than 40%. Furthermore, it is understood that the thermal resistance ratio further becomes low when the above-mentioned ratio "L6/L5 is within a range of 70% to 95%. For this reason, the thermal resistance can be reduced by setting the sizes of the thermally conductive member 2 and the semiconductor element 1 so that the above-mentioned ratio is equal to or more than 40%, preferably is within the range of 70% to 95%. Similarly, the thermal resistance can be reduced by setting the sizes of the thermally conductive member 2 and the semiconductor element 1 so that the ratio of the area where the semiconductor element 1 and the thermally conductive member 2 overlap one another in planar view with respect to the area of the semiconductor element 1 in planar view is equal to or more than 40%, preferably is within the range of 70% to 95%.

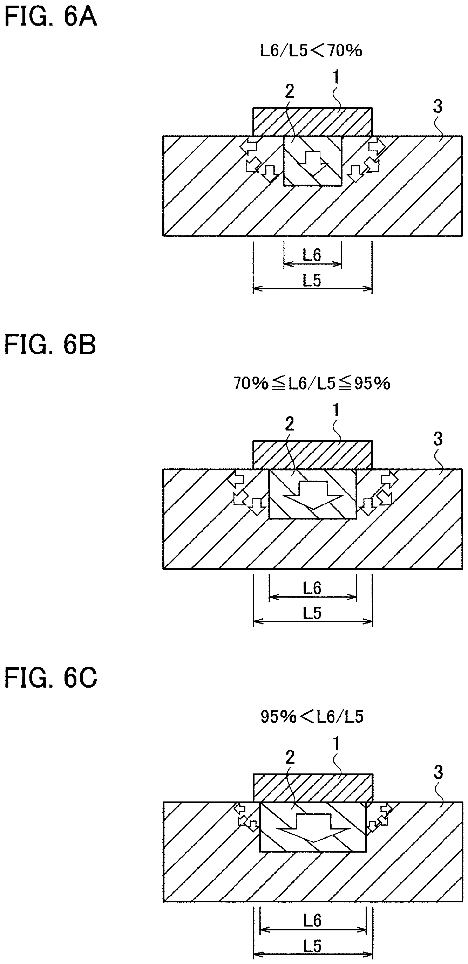

Next, with reference to the explanatory diagrams showing in Figs. 6A, 6B, and 6C, transmission of heat generated in the semiconductor element 1 will now be described. Figs. 6A to 6C are explanatory diagrams showing a Y-Z-axial plane of the semiconductor device. Fig. 6A shows a configuration when the ratio "L6/L5" is less than 70%, Fig. 6B shows a configuration when the ratio "L6/L5" is 70 to 95%, and Fig. 6C shows the configuration when the ratio "L6/L5" is more than 95%.

As shown in Fig. 6A, when the ratio "L6/L5" is less than 70%, the heat generated in the semiconductor element 1 is diffused through the thermally conductive member 2 in the X-axis and Z-axial directions. Furthermore, the heat can be three-dimensionally diffused to a non-contact region where the semiconductor element 1 is not in contact with the thermally conductive member 2 (region where the semiconductor element 1 is in contact with the metal member 3). Consequently, the effect of improving the thermal dispersion effect of the semiconductor element 1 can be obtained.

As shown in Fig. 6C, when the ratio "L6/L5" is more than 95%, the heat generated in the semiconductor element 1 can be diffused through the thermally conductive member 2 in the X-axis and Z-axial directions, and the heat can be further three-dimensionally diffused to the region where the semiconductor element 1 is in contact with the metal member 3. Consequently, the effect of improving the thermal dispersion effect of the semiconductor element 1 can be obtained.

As shown in Fig. 6B, when the ratio "L6/L5" is within the range of 70% to 95%, the non-contact region where the semiconductor element 1 is not in contact with the thermally conductive member 2 (region where the semiconductor element 1 is in contact with the metal member 3 touch) exists at a rate of 5% to 30%. Consequently, the heat generated in the semiconductor element 1 is diffused in a wide range of the thermally conductive member 2 for a short time, and the diffused heat is transferred to the metal member 3 through the non-contact region. That is, it is possible to diffuse the heat generated in the semiconductor element 1 to the wide range at an early stage, and thereafter to transfer the heat to the entire metal member 3 by three-dimensional diffusion with extremely high efficiency. Accordingly, the total amount of the diffusion of heat is increased.

This is caused by three-dimensionally diffusing the heat through the metal members 3, such as copper, whereas the highly thermally conductive direction of the thermally conductive members 2, such as graphite, is merely two directions of the X-axis and the Z-axis, i.e., two-dimensional diffusion.

In other words, the present embodiment proves that the thermal resistance can be reduced and the thermal dispersion effect can be further improved by setting the ratio "L6/L5" to equal to or more than 40%, preferably within the range of 70% to 95%, or by setting the ratio of the area where the semiconductor element 1 and the thermally conductive member 1 overlap one another with respect to the area of the semiconductor element 1 in planar view to equal to or more than 40% , preferably within the range of 70% to 95%.

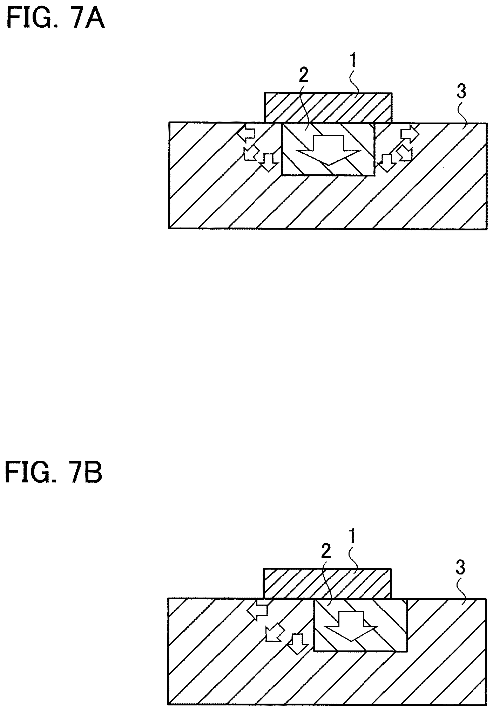

Next, the reason for covering the semiconductor element 1 with the thermally conductive member 2 in the Y-axial direction will now be described. Figs. 7A and 7B are explanatory diagrams showing a positional relationship of the semiconductor element 1 with respect to the thermally conductive member 2 in the Y-axial direction. Fig. 7A shows a case where an upper surface of the thermally conductive member 2 is covered with the semiconductor element 1, and Fig. 7B shows a case where a part of the thermally conductive member 2 is exposed therefrom.

As shown in Fig. 7A, when the center of the thermally conductive member 2 and the center of the semiconductor element 1 coincide with each other, the heat dissipated from the semiconductor element 1 is efficiently diffused through the thermally conductive member 2 and the metal member 3, and thereby the heat dissipation efficiency can be improved and the thermal resistance can be reduced.

On the other hand, as shown in Fig. 7B, when the center of thermally conductive member 2 is deviated from the center of the semiconductor element 1 and a part of the thermally conductive member 2 is exposed therefrom in the Y-axial direction, the heat cannot be three-dimensionally diffused at one end. Therefore, the thermal resistance is increased. In other words, it is proved that the thermal resistance can be reduced by arranging each end (both ends) in the Y-axial direction of the semiconductor element 1 so as to be in contact with the front side surface of the metal member 3, in the present embodiment.

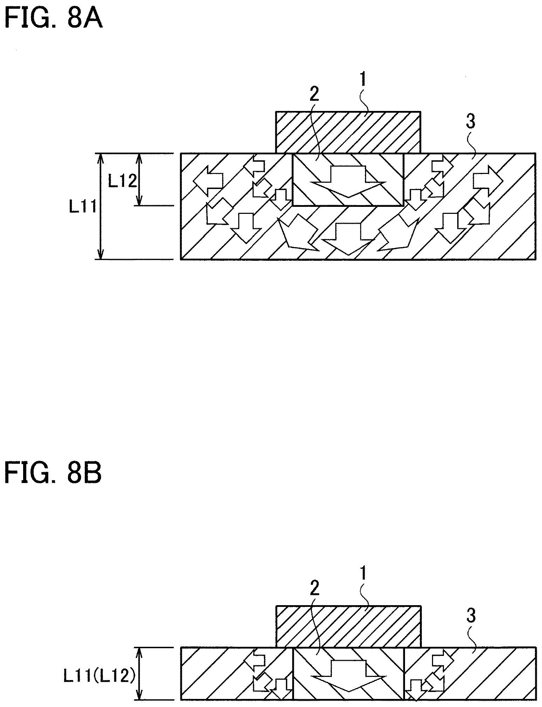

Next, the reason for setting the thickness L11 of the metal member 3 to be larger than the thickness L12 of the thermally conductive member 2 will now be described. Fig. 8A is an explanatory diagram showing a state of thermal dissipation at the time of L11>L12, and Fig. 8B is an explanatory diagram showing a state of thermal dissipation at the time of L1 1=L12.

Fig. 8A and Fig. 8B respectively show Y-Z-axial planes of the semiconductor device. As shown in Fig. 8A, the metal member 3 exists on a lower surface of the thermally conductive member 2 at the time of L11>L12, the heat diffused through the thermally conductive member 2 is diffused in right-left directions and downward direction in Fig. 8A. On the other hand, at the time of L11=L12 as shown in Fig. 8B, since no metal member 3 exists at the lower side of the thermally conductive member 2, the heat diffused through the thermally conductive member 2 is diffused only in right-left directions in Fig. 8B. Consequently, the thermal resistance becomes large and therefore the heat dissipation efficiency is reduced. In other words, it is proved that the heat dissipation efficiency can be improved and the thermal resistance can be reduced, by setting the thickness of the metal member 3 to be larger than the thickness of the thermally conductive member 2, in the present embodiment.

Next, the reason for setting length (L3 and L4 shown in Fig. 1) of the region of the both ends of the thermally conductive member 2 which is not in contact with the semiconductor element 1 to be equal to or more than the thickness (L11 shown in Fig. 2) of the metal member 3 in the X-axial direction will now be described.

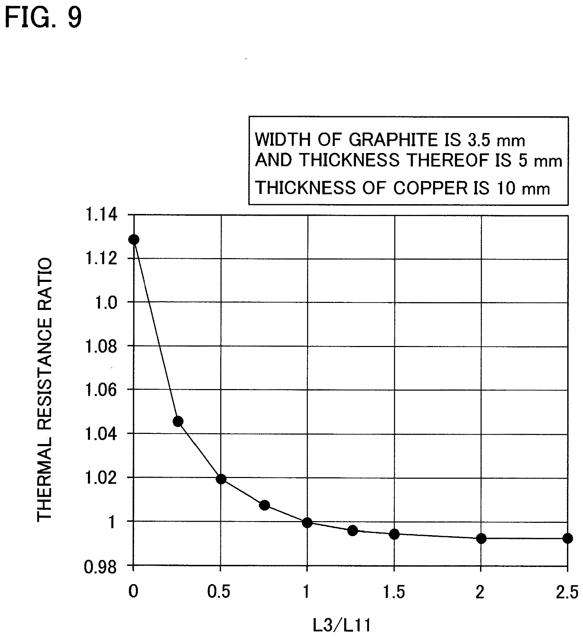

Fig. 9 shows a graphic chart in which the horizontal axis is the ratio "L3/L11" between the length L3 (or L4) shown in Fig. 1 and the thickness L11 of the thermally conductive member 2, and the vertical axis is the thermal resistance ratio. The thermal resistance ratio of the vertical axis is obtained by normalizing "L3/L11" with "1". In Fig. 9, the width (length in the Y-axial direction) of the thermally conductive member 2 is 3.5 mm, the thickness (length in the Z-axial direction) thereof is 5 mm, and the thickness of the metal member 3 is 10 mm. It is understood from Fig. 9 that the above-mentioned ratio "L3/L11" largely changes when the thermal resistance ratio is less than "1", but the thermal resistance ratio becomes approximately a certain value when the thermal resistance ratio is equal to or more than "1". In other words, when the length L3 (or L4) shown in Fig. 1 is set as the thickness L11 of the thermally conductive member 2 (i.e., L3=L11), the thermal resistance can be substantially made into the minimum value. That is, it is proved that the heat dissipation efficiency can be improved and the thermal resistance can be reduced in an X-axial direction by setting the length of the region of the both ends of the thermally conductive member 2 which is not in contact with the semiconductor element 1 to be equal to or more than the thickness of metal member 3.

### [Description of the effects of the present embodiment]

The following effects can be obtained in the semiconductor device according to the present embodiment.

(1) Since the thermally conductive member 2 is provided in the groove M of the rectangular shape formed on the metal member 3 and the semiconductor element 1 is bonded so as to be in contact with this thermally conductive member 2, the heat dissipation efficiency of the heat generated in the semiconductor element 1 can be improved. Consequently, it becomes possible to miniaturize the semiconductor device.
(2) Since the cooling apparatus 4 for thermally dissipating heat of the metal member 3 is provided on the back side surface of the metal member 3, the heat diffused to the metal member 3 can be efficiently dissipated through the cooling apparatus 4.
(3) The heat dissipation efficiency can be improved by setting the ratio "L6/L5" of the length L6 in the Y-axial direction of the thermally conductive member 2 with respect to the length L5 in the Y-axial direction of the semiconductor element 1 to be equal to or more than 40%, preferably to be within a range of 70% to 95%. Furthermore, the heat dissipation efficiency can be improved by setting the overlapped area in normal direction view between the semiconductor element 1 and the thermally conductive member 2 with respect to the area in normal direction view of the front side surface of the semiconductor element 1 to be equal to or more than 40%, preferably to be within a range of 70% to 95%. Moreover, even when the width L6 (the length in the Y-axial direction in Fig. 1) of the thermally conductive member 2 varies, the variation in the heat dissipation efficiency can be suppressed.

For example, when the length L6 of the Y-axial direction of thermally conductive member 2 is smaller than the length to be expected (when it is inevitably small due to manufacturing errors, or the like), the quantity of heat which can be diffused through the thermally conductive member 2 is reduced. However, the amount of heat which can be diffused through the metal member 3 is increased since the area of contacting between the metal member 3 and the semiconductor element 1 is increased accordingly. Consequently, the effect on the thermal resistance resulting from the variation in the length L6 in the Y-axial direction of the thermally conductive member 2 can be suppressed by setting the above-mentioned ratio "L6/L5" to be equal to or more than 40%, preferably to be within a range of 70% to 95%.

Moreover, since it is not necessary to increase the length L6 in the Y-axial direction of the thermally conductive member 2 more than necessary, the amount of the thermally conductive member 2 to be used can be reduced, and therefore it is possible to reduce the cost.

(4) The ends of the semiconductor element 1 are in contact with the front side surface of the metal member 3 in the low heat conduction direction (Y-axial direction, i.e., the second axial direction) of the thermally conductive member 2. Consequently, the heat generated in the semiconductor element 1 can be three-dimensionally diffused through the metal member 3, and therefore the thermal resistance can further be reduced.

(5) Since the thickness L12 of the metal member 3 is larger than the thickness L11 of thermally conductive member 2, and therefore the heat two-dimensionally diffused through the thermally conductive member 2 can further be three-dimensionally diffused through the metal member 3, the thermal resistance can be reduced.

(6) The length L2 in the X-axial direction of the thermally conductive member 2 is longer than the length L1 in the X-axial direction of the semiconductor element 1; and the length L3 from one end in the X-axial direction of the semiconductor element 1 to one end in the X-axial direction of the thermally conductive member 2 and the length L4 from the other end in the X-axial direction of the semiconductor element 1 to the other end in the X-axial direction of the thermally conductive member 2 are equal to or more than the thickness L11 of the metal member 3, i.e., the length in the normal direction with respect to the front side surface. Therefore, the thermal resistance in the X-axial direction can be reduced with respect to the thermal resistance in the thickness direction (Z-axial direction), the heat can be thermally dissipated through the cooling apparatus 4 after preferentially diffusing the heat in the X-axial direction, and the thermal resistance can further be reduced.

(7) Since the thermally conductive member 2 is formed by laminating strip-shaped graphite, and the graphite has the anisotropy of thermal conduction, the heat generated in the semiconductor element 1 can be efficiently diffused in the X-axial direction.

Although in the above-described embodiment, an example has been described in which the front side surface of the metal member 3 and the front side surface of the thermally conductive member 2 are flush with each other, it is also possible to adopt a configuration in which there is a level difference between the front side surface of the metal member 3 and the front side surface of the thermally conductive member 2. In this case, a level difference may also be formed in the bonded surface of the semiconductor element 1.

### REFERENCE SIGNS LIST

- 1: Semiconductor Element
- 2: Thermally Conductive Member (Graphite or the like)
- 3: Metal Member (Copper or the like)
- 4: Cooling Apparatus

## Claims

1. A semiconductor device comprising:
a metal member (3) having a groove formed on a front side surface thereof;
a thermally conductive member (2) provided in an inside of the groove and having a thermal conductivity in a first axial direction (x-direction) on the front side surface higher than a thermal conductivity in a second axial direction (y-direction) orthogonal to the first axial direction (x-direction) on the front side surface; and
a semiconductor element (1) provided on the front side surface of the metal member (3), and at least a part of which is in contact with the thermally conductive member (2), **characterized in that**:
one end of the semiconductor element (1) extends in the second axial direction (y-direction) beyond one end of the thermally conductive member (2), and
the other end of the semiconductor element (1) extends in the second axial direction (y-direction) beyond the other end of the thermally conductive member (2)

2. The semiconductor device according to claim 1, wherein
a ratio of a length in the second axial direction of the thermally conductive member (2) with respect to a length in the second axial direction of the semiconductor element (1) is equal to or more than 40%_

3. The semiconductor device according to claim 2, wherein
the ratio of the length in the second axial direction of the thermally conductive member (2) with respect to the length in the second axial direction of the semiconductor element (1) is equal to or less than 95%.

4. The semiconductor device according to any one of claims 1-3, wherein
a ratio of an area where the semiconductor element (1) and the thermally conductive member (2) overlap one another in normal direction view with respect to an area of the front side surface of the semiconductor element (1) in normal direction view is equal to or more than 40%

5. The semiconductor device according to claim 4, wherein
the ratio of the area where the semiconductor element (1) and the thermally conductive member (2) overlap one another in normal direction view with respect to the area of the front side surface of the semiconductor element (1) in normal direction view is equal to or less than 95%

6. The semiconductor device according to any one of claims 1-5, wherein
a length in the normal direction with respect to the front side surface of the metal member (3) is longer than a length in the normal direction with respect to the front side surface of the thermally conductive member (2).

7. The semiconductor device according to any one of claims 1-6, wherein:
a length in the first axial direction of the thermally conductive member (2) is longer than a length in the first axial direction of the semiconductor element (1); and
a length from one end in the first axial direction of the semiconductor element (1) to one end in the first axial direction of the thermally conductive member (2) and a length from the other end in the first axial direction of the semiconductor element (1) to the other end in the first axial direction of the thermally conductive member (2) are equal to or more than a length in the normal direction with respect to the front side surface of the metal member (3).

8. The semiconductor device according to any one of claims 1-7, wherein
the thermally conductive member (2) is formed by laminating strip-shaped graphite.

9. The semiconductor device according to any one of claims 1-8, wherein
a cooling apparatus (4) for thermally dissipating heat of the metal member (3) is provided on a back side surface opposite to the front side surface of the metal member (3).

## Patentansprüche

1. Halbleitervorrichtung umfassend:
ein Metallelement (3), das eine an einer vorderen Seitenoberfläche davon geformte Nut aufweist;
ein wärmeleitfähiges Element (2), das in einer Innenseite der Nut vorgesehen ist und eine Wärmeleitfähigkeit in einer ersten axialen Richtung (x-Richtung) an der vorderen Seitenoberfläche aufweist, die höher ist als eine Wärmeleitfähigkeit in einer zweiten axialen Richtung (y-Richtung) orthogonal zur ersten axialen Richtung (x-Richtung) an der vorderen Seitenoberfläche; und
ein Halbleiterelement (1), das an der vorderen Seitenoberfläche des Metallelements (3) vorgesehen ist und von dem mindestens ein Abschnitt in Kontakt mit dem wärmeleitfähigen Element (2) steht, **dadurch gekennzeichnet, dass**
ein Ende des Halbleiterelements (1) sich in der zweiten axialen Richtung (y-Richtung) über ein Ende des wärmeleitfähigen Elements (2) erstreckt, und
das andere Ende des Halbleiterelements (1) sich in der zweiten axialen Richtung (y-Richtung) über das andere Ende des wärmeleitfähigen Elements (2) erstreckt.

2. Halbleitervorrichtung nach Anspruch 1, wobei
ein Verhältnis einer Länge in der zweiten axialen Richtung des wärmeleitfähigen Elements (2) in Bezug auf eine Länge in der zweiten axialen Richtung des Halbleiterelements (1) gleich oder mehr als 40% beträgt.

3. Halbleitervorrichtung nach Anspruch 2, wobei
das Verhältnis der Länge in der zweiten axialen Richtung des wärmeleitfähigen Elements (2) in Bezug auf die Länge in der zweiten axialen Richtung des Halbleiterelements (1) gleich oder kleiner als 95% ist.

4. Halbleitervorrichtung nach einem der Ansprüche 1 bis 3, wobei
ein Verhältnis einer Fläche, wobei das Halbleiterelement (1) und das wärmeleitfähige Element (2) einander in normaler Richtungsansicht überlappen, in Bezug auf eine Fläche der vorderen Seitenoberfläche des Halbleiterelements (1) in normaler Richtungsansicht gleich oder mehr als 40% beträgt.

5. Halbleitervorrichtung nach Anspruch 4, wobei
das Verhältnis der Fläche, wobei das Halbleiterelement (1) und das wärmeleitfähige Element (2) einander in normaler Richtungsansicht überlappen, in Bezug auf die Fläche der vorderen Seitenoberfläche des Halbleiterelements (1) in normaler Richtungsansicht gleich oder kleiner als 95% ist.

6. Halbleitervorrichtung nach einem der Ansprüche 1 bis 5, wobei
eine Länge in der normalen Richtung in Bezug auf die vordere Seitenoberfläche des Metallelements (3) länger ist als eine Länge in der normalen Richtung in Bezug auf die vordere Seitenoberfläche des wärmeleitfähigen Elements (2).

7. Halbleitervorrichtung nach einem der Ansprüche 1 bis 6, wobei:
eine Länge in der ersten axialen Richtung des wärmeleitfähigen Elements (2) größer ist als eine Länge in der ersten axialen Richtung des Halbleiterelements (1); und
eine Länge von einem Ende in der ersten axialen Richtung des Halbleiterelements (1) zu einem Ende in der ersten axialen Richtung des wärmeleitfähigen Elements (2) und eine Länge von dem anderen Ende in der ersten axialen Richtung des Halbleiterelements (1) zu dem anderen Ende in der ersten axialen Richtung des wärmeleitfähigen Elements (2) gleich oder größer sind als eine Länge in der normalen Richtung in Bezug auf die vordere Seitenoberfläche des Metallelements (3).

8. Halbleitervorrichtung nach einem der Ansprüche 1 bis 7, wobei
das wärmeleitfähige Element (2) durch Laminieren von streifenförmigem Graphit geformt ist.

9. Halbleitervorrichtung nach einem der Ansprüche 1 bis 8, wobei
eine Kühlvorrichtung (4) zur thermischen Ableitung von Wärme des Metallelements (3) an einer hinteren Seitenoberfläche gegenüber der vorderen Seitenoberfläche des Metallelements (3) vorgesehen ist.

## Revendications

1. Dispositif à semi-conducteur comprenant :
un élément métallique (3) ayant une rainure formée sur une surface avant de celui-ci ;
un élément thermiquement conducteur (2) prévu à l'intérieur de la rainure et ayant une conductivité thermique dans une première direction axiale (direction x) sur la surface avant supérieure à une conductivité thermique dans une seconde direction axiale (direction y) orthogonale à la première direction axiale (direction x) sur la surface avant ; et
un élément semi-conducteur (1) prévu sur la surface avant de l'élément métallique (3), et dont au moins une partie est en contact avec l'élément thermiquement conducteur (2),
**caractérisé en ce que** :
une extrémité de l'élément semi-conducteur (1) s'étend dans la seconde direction axiale (direction y) au-delà d'une extrémité de l'élément thermiquement conducteur (2), et
l'autre extrémité de l'élément semi-conducteur (1) s'étend dans la seconde direction axiale (direction y) au-delà de l'autre extrémité de l'élément thermiquement conducteur (2).

2. Dispositif à semi-conducteur selon la revendication 1, dans lequel
un rapport d'une longueur dans la seconde direction axiale de l'élément thermiquement conducteur (2) par rapport à une longueur dans la seconde direction axiale de l'élément semi-conducteur (1) est supérieur ou égal à 40%.

3. Dispositif à semi-conducteur selon la revendication 2, dans lequel
le rapport de la longueur dans la seconde direction axiale de l'élément thermiquement conducteur (2) par rapport à la longueur dans la seconde direction axiale de l'élément semi-conducteur (1) est inférieur ou égal à 95%.

4. Dispositif à semi-conducteur selon l'une quelconque des revendications 1 à 3, dans lequel
un rapport d'une superficie dans laquelle l'élément semi-conducteur (1) et l'élément thermiquement conducteur (2) se chevauchent dans une vue de direction normale par rapport à une superficie de la surface avant de l'élément semi-conducteur (1) dans une vue de direction normale est supérieur ou égal à 40%.

5. Dispositif à semi-conducteur selon la revendication 4, dans lequel
le rapport de la superficie dans laquelle l'élément semi-conducteur (1) et l'élément thermiquement conducteur (2) se chevauchent dans une vue de direction normale par rapport à la superficie de la surface avant de l'élément semi-conducteur (1) dans une vue de direction normale est inférieur ou égal à 95%.

6. Dispositif à semi-conducteur selon l'une quelconque des revendications 1 à 5, dans lequel
une longueur dans la direction normale par rapport à la surface avant de l'élément métallique (3) est supérieure à une longueur dans la direction normale par rapport à la surface avant de l'élément thermiquement conducteur (2).

7. Dispositif à semi-conducteur selon l'une quelconque des revendications 1 à 6, dans lequel :
une longueur dans la première direction axiale de l'élément thermiquement conducteur (2) est supérieure à une longueur dans la première direction axiale de l'élément semi-conducteur (1) ; et
une longueur à partir d'une extrémité dans la première direction axiale de l'élément semi-conducteur (1) à une extrémité dans la première direction axiale de l'élément thermiquement conducteur (2) et une longueur de l'autre extrémité dans la première direction axiale de l'élément semi-conducteur (1) à l'autre extrémité dans la première direction axiale de l'élément thermiquement conducteur (2) sont supérieures ou égales à une longueur dans la direction normale par rapport à la surface avant de l'élément métallique (3).

8. Dispositif à semi-conducteur selon l'une quelconque des revendications 1 à 7, dans lequel
l'élément thermiquement conducteur (2) est formé par stratification de graphite en forme de bande.

9. Dispositif à semi-conducteur selon l'une quelconque des revendications 1 à 8, dans lequel
un appareil de refroidissement (4) pour dissiper thermiquement la chaleur de l'élément métallique (3) est prévu sur une surface arrière opposée à la surface avant de l'élément métallique (3).
